**Europäisches Patentamt**

**European Patent Office**

**Office européen des brevets**

(19)

(11) Veröffentlichungsnummer: **0 250 624**
**B1**

(12) # EUROPÄISCHE PATENTSCHRIFT

(45) Veröffentlichungstag der Patentschrift:
**03.10.90**

(51) Int. Cl.⁵: **H01L 39/24**

(21) Anmeldenummer: **86108845.8**

(22) Anmeldetag: **28.06.86**

(54) Verbundsupraleiter mit Filamenten aus einer intermetallischen Verbindung.

(43) Veröffentlichungstag der Anmeldung:
**07.01.88 Patentblatt 88/1**

(45) Bekanntmachung des Hinweises auf die Patenterteilung:
**03.10.90 Patentblatt 90/40**

(84) Benannte Vertragsstaaten:
**CH DE FR GB LI**

(56) Entgegenhaltungen:
**EP-A- 0 054 421**

(73) Patentinhaber: **VACUUMSCHMELZE GMBH, Grüner Weg 37 Postfach 2253, D-6450 Hanau 1(DE)**

(72) Erfinder: **Springer, Engelbert, Dr., Ulmenstrasse 23, D-6458 Rodenbach(DE)**
Erfinder: **Kirchner, Werner, Wolfsgrund 16, D-6497 Steinau(DE)**

**Beschreibung**

Die Erfindung betrifft einen Verbundsupraleiter mit Filamenten aus einer intermetallischen Verbindung mit A-15-Phase, die durch querschnittsvermindernde Verformung gebildet werden, aus Nb₃Sn oder V₃Ga bestehen und durch Diffusion aus einer bei Reaktionstemperatur flüssigen zinn- bzw. galliumreichen Bronze sowie Niob- bzw. Vanadiummaterial gebildet werden, wobei über den Leiterquerschnitt verteilt und von Niob- bzw. Vanadiummaterial umgebene Bereiche einer zinn- bzw. galliumreichen Bronze vorhanden sind.

Ein derartiger Verbundsupraleiter ist beispielsweise aus JOURNAL OF APPLIED PHYSICS 59 (11) Nov. 1982, Seiten 7479 bis 7485 bekannt. Der hierin beschriebene Supraleiter besteht aus über den Querschnitt verteilten Stäben aus einer zinnreichen Bronze mit 12 Atom.-% Kupfer, die von einer Niobmatrix umgeben sind. Die Niobmatrix wird dadurch gebildet, daß die Stäbe aus einer zinnreichen Bronze in Hüllrohre aus Niob eingebracht werden und das so aus mehreren Stäben zusammengesetzte Verbundmaterial durch Kaltverformung auf einen kleineren Querschnitt gezogen wird. Eine Reaktionsglühung bei etwa 700°C läßt Zinn und Niob ineinander diffundieren und die supraleitende intermetallische Verbindung Nb₃Sn an den Diffusionsstellen entstehen.

Ein ähnlicher Verbundsupraleiter, der Stäbe aus Niob in einer Kupfer/Zinn-Matrix aufweist, ist aus EP-A 0 054 421 bekannt. Dabei werden Kupfer und Zinn in elementarer Form, z.B. durch Pulverkompaktierung, eingebracht.

Die Verwendung einer zinnreichen Bronze als Zinnquelle für die Bildung der intermetallischen Verbindung Nb₃Sn bietet den Vorteil, daß nur geringe Querschnittsanteile zur Bereitstellung der nötigen Zinnmenge vorgesehen werden müssen, ein Nachteil besteht jedoch darin, daß wegen des niedrigen Schmelzpunktes von Zinn bei der querschnittsvermindernden Verformung des Leiters weitgehend auf Zwischenglühungen verzichtet werden muß. Diese notwendige Kaltverformung kann leicht zu schlechter Bondbildung bei einem Verbundsupraleiter mit vielen Filamenten führen und es können bei der Verarbeitung leicht Leiterabrisse auftreten.

Aufgabe der vorliegenden Erfindung ist es, den Querschnitt eines Supraleiters so aufzubauen, daß seinerseits eine gute Kaltverformbarkeit mit geringer Abrissgefahr und andererseits eine gute Verbindung der einzelnen Bereiche des Verbundleiters erreicht wird.

Diese Aufgabe wird erfindungsgemäß durch die im Kennzeichen des Patentanspruchs 1 genannten Merkmale und durch die Merkmale aus den Unteransprüchen gelöst.

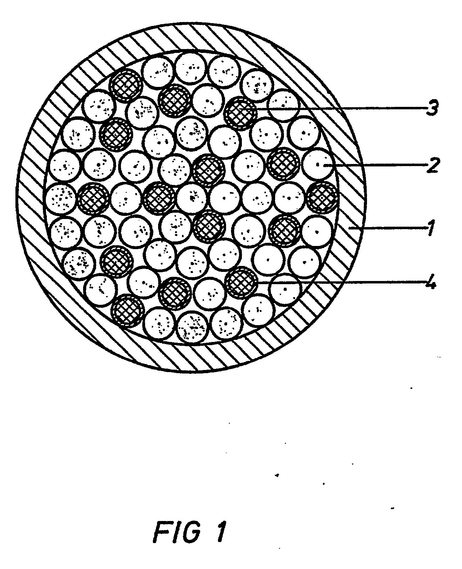

Als Beispiel für einen erfindungsgemäßen Supraleiter ist ein Querschnitt des Supraleiters vor Beginn der querschnittsvermindernden Verformung in der Zeichnung dargestellt. In einem Hüllrohr 1 aus Kupfer befindet sich ein Bündel von Stäben. Die Stäbe 2 bestehen dabei im wesentlichen aus Niob für den Fall, daß ein Verbundleiter mit dem supraleitenden Material Nb₃Sn hergestellt werden soll, oder aus Vanadium, wenn als supraleitende Phase V₃Ga gewählt wird. Im folgenden wird angenommen, daß der Supraleiter aus Niob und Zinn gebildet werden soll. Für Vanadium und Gallium gelten die Ausführungen entsprechend.

Zwischen den Stäben 2 aus Niob, die zur Trennung voneinander ein dünnes Hüllrohr, z.B. aus Kupfer, besitzen, sind Stäbe 3 angeordnet, die aus einer zinnreichen Bronze bestehen. Es hat sich als vorteilhaft herausgestellt, wenn der Kupferanteil im Bereich von 3 bis 12 Atom.-%, vorzugsweise bei 6 bis 8 Atom.-%, liegt.

Erfindungsgemäß sind die Stäbe 3 aus der zinnreichen Bronze von Rohren 4 umgeben, deren Material aus einer kupferreichen Bronze besteht. Hier sind besonders vorteilhaft Kupferlegierungen mit einem Zinnanteil von 0,5 bis 2 Atom.-%, mit einem Zirkoniumanteil von mehr als 0 bis 0,1 Atom.-%, einem Anteil von Titan im Bereich von 5 bis 7 Atom.-%, von Gallium im Bereich von 0,5 bis 2 Atom.-% oder von Beryllium in der Größenordnung von 0,5 bis 2 Atom.-%.

Jeder dieser Zusätze erhöht die Festigkeit des Kupfers und gestattet damit, relativ zu reinem Kupfer dünnwandige Rohre 4 einzusetzen. Weiterhin ergibt sich durch die Zusätze von Fremdatomen im Kupfer der Rohre 4 eine Verbesserung der Diffusion und der Bondbildung, z.B. mit den kupferummantelten Stäben 2 aus Niob. Obgleich alle genannten Zusätze zum Kupfer für das Material der Rohre 4 mehr oder weniger die erfindungsgemäßen Vorteile bringen, ist es besonders vorteilhaft, wenn man im Falle von niobhaltigen Stäben Zinn in einer Menge von 1,5 Atom.-% oder im Falle von Vanadiumstäben Gallium in einer Menge von etwa 1 Atom.-% zusetzt.

Die Niobstäbe können dabei wahlweise aus festem Niob, Niobpulver oder einem Niob-Kupfer-Pulvergemisch bestehen.

Im letzteren Fall bilden sich fadenförmige Niobbereiche innerhalb jedes aus den Stäben 2 durch querschnittsvermindernde Verformung gebildeten Filamentes.

Querschnitt und Anzahl der Stäbe 3 aus zinnreicher Bronze werden dabei so gewählt, daß für die Bildung einer gewünschten Stärke der intermetallischen Phase Nb₃Sn eine gerade ausreichende Menge Zinn über den Leiterquerschnitt verteilt zur Verfügung steht.

Durch die über den Leiterquerschnitt verteilten Zinnquellen ergibt sich bei den querschnittsvermindernden Verformungsschritten wie Ziehen, Walzen, Hämmern oder Pressen eine gleichmäßige Verformung der einzelnen Querschnittsbereiche. Außerdem erhält man gegenüber Leitern mit nur einer Zinnquelle günstigere Diffusionsbedingungen, da der Diffusionsweg des Zinns relativ klein ist, so daß sich gleichmäßigere Nb₃Sn-Schichten ergeben.

Anstelle der in der Zeichnung dargestellten runden Querschnitte für die Stäbe 2 und 3 können auch andere Querschnitte, insbesondere sechseckige Querschnitte, verwendet werden. Es hat sich herausgestellt, daß bei Wahl eines sechseckigen Querschnitts die Bondbildung weiter verbessert wird und sich eine besonders gleichmäßige Verformung der einzelnen Stäbe zu Filamenten ergibt. Will man sehr

viele Filamente in einem Querschnitt unterbringen, läßt sich dies wegen der sehr hohen Kaltverformbarkeit von weit über 90 % des erfindungsgemäßen Verbundes in bekannter Weise durch Mehrfachbündelung erreichen.

**Patentansprüche**

1. Verbundsupraleiter mit Filamenten aus einer intermetallischen Verbindung mit A-15-Phase, die durch querschnittsvermindernde Verformung gebildet werden, aus $Nb_3Sn$ oder $V_3Ga$ bestehen und durch Diffusion aus einer bei Reaktionstemperatur flüssigen zinn- bzw. galliumreichen Bronze sowie Niob- bzw. Vanadiummaterial gebildet werden, wobei über den Leiterquerschnitt verteilt und von Niob- bzw. Vanadiummaterial umgebene Bereiche einer zinn- bzw. galliumreichen Bronze vorhanden sind,
**dadurch gekennzeichnet,**
daß der Leiterquerschnitt vor der Verformung aus einem Bündel von Stäben (2, 3) besteht,
daß die Stäbe (2) Niob bzw. Vanadium enthalten und die Stäbe (3) aus einer zinn- bzw. galliumreichen Bronze bestehen und
daß mindestens die Stäbe (3) aus zinn- bzw. galliumreicher Bronze von je einem Rohr (4) aus einer kupferreichen Bronze umgeben sind.

2. Verbundsupraleiter nach Anspruch 1,
**dadurch gekennzeichnet,**
daß das Material der Rohre (4) aus einer kupferreichen Bronze mit geringem Zusatz von Zinn bzw. Gallium besteht.

3. Verbundsupraleiter nach Anspruch 2,
**dadurch gekennzeichnet,**
daß der Zusatz zwischen 0,5 und 2 Atom.-% Zinn bzw. Gallium beträgt.

4. Verbundsupraleiter nach Anspruch 1,
**dadurch gekennzeichnet,**
daß die Stäbe (2) aus Niob bestehen und eine Kupferhülle besitzen.

5. Verbundsupraleiter nach Anspruch 1,
**dadurch gekennzeichnet,**
daß die Stäbe (2) ein Pulvergemisch aus Niob und Kupfer enthalten.

6. Verbundsupraleiter nach Anspruch 1,
**dadurch gekennzeichnet,**
daß die Stäbe (2, 3) sechseckigen Querschnitt aufweisen.

**Claims**

1. A compound superconductor with filaments made of an intermetallic compound in the A-15-phase, which are formed by cross-section-reducing deformation, comprise $Nb_3Sn$ or $V_3Ga$ and are produced by diffusion from bronze rich in tin or gallium and liquid at the reaction temperature and from niobium or vanadium material respectively, where zones comprising bronze rich in tin or gallium and surrounded by niobium or vanadium material respectively are distributed over the conductor cross-section, characterised in that prior to the deformation the conductor cross-section comprises a bundle of rods (2, 3),
that the rods (2) contain niobium or vanadium and the rods (3) comprise bronze rich in tin or gallium respectively and
that at least the rods made of bronze rich in tin or gallium are each surrounded by a tube made of bronze rich in copper.

2. A compound superconductor as claimed in claim 1, characterised in that the material of the tubes (4) comprises bronze rich in copper with a small addition of tin or gallium.

3. A compound superconductor as claimed in claim 2, characterised in that the addition amounts to between 0.5 and 2 atom-% tin or gallium.

4. A compound superconductor as claimed in claim 1, characterised in that the rods (2) comprise niobium and have a copper covering.

5. A compound superconductor as claimed in claim 1, characterised in that the rods (2) contain a powder mixture of niobium and copper.

6. A compound superconductor as claimed in claim 1, characterised in that the rods (2, 3) have a hexagonal cross-section.

**Revendications**

1. Supraconducteur composite à filaments d'un composé intermétallique à phase A-15 obtenu par une déformation avec réduction de section, formé de $Nb_3Sn$ ou $V_3Ga$ et obtenu par diffusion à partir de bronze riche en zinc ou en gallium, liquide à la température de réaction ou encore de niobium ou de vanadium, et réparti sur la section du conducteur ainsi que deux zones d'un bronze riche en zinc ou en gallium entourées de niobium ou de vanadium, supraconducteur caractérisé en ce qu'avant déformation, la section conductrice est formée d'un faisceau de tiges (2, 3),
les tiges (2) contiennent du niobium ou du vanadium et les tiges (3) sont en un bronze riche en zinc ou en gallium et,
au moins les tiges (3) de bronze riche en zinc ou en gallium sont entourées chaque fois par un tube (4) en bronze riche en cuivre.

2. Supraconducteur composite selon la revendication 1, caractérisé en ce que la matière des tubes (4) est un bronze riche en cuivre avec faible addition de zinc ou de gallium.

3. Supraconducteur composite selon la revendication 2, caractérisé en ce que l'additif est compris entre 0,5 et 2 % atomique de zinc ou de gallium.

4. Supraconducteur composite selon la revendication 1, caractérisé en ce que les tiges (2) sont en niobium et ont une gaine en cuivre.

5. Supraconducteur composite selon la revendication 1, caractérisé en ce que les tiges (2) contiennent un mélange de poudre en niobium et en cuivre.

6. Supraconducteur composite selon la revendication 1, caractérisé en ce que les tiges (2, 3) ont une section hexagonale.

EP 0 250 624 B1

FIG 1